Europäisches Patentamt

European Patent Office

Office européen des brevets

(19)

(11) Numéro de publication : **0 409 697 B1**

## (12) FASCICULE DE BREVET EUROPEEN

(45) Date de publication du fascicule du brevet :
**15.09.93 Bulletin 93/37**

(51) Int. Cl.$^5$ : **G11C 17/00, G11C 11/56**

(21) Numéro de dépôt : **90402010.4**

(22) Date de dépôt : **12.07.90**

(54) **Circuit intégré MOS à tension de seuil ajustable.**

(30) Priorité : **20.07.89 FR 8909780**

(43) Date de publication de la demande :
**23.01.91 Bulletin 91/04**

(45) Mention de la délivrance du brevet :
**15.09.93 Bulletin 93/37**

(84) Etats contractants désignés :
**DE ES GB IT NL**

(56) Documents cités :
**EP-A- 0 280 883**
**US-A- 4 357 685**
**US-A- 4 495 602**
**US-A- 4 720 816**

(73) Titulaire : **GEMPLUS CARD INTERNATIONAL**
**avenue du Pic de Bertagne, Parc d'activités**
**de la Plaine de Jouques**
**F-13420 Gemenos (FR)**

(72) Inventeur : **Kowalski, Jacek**
**Cabinet Ballot-Schmit, 7, rue le Sueur**
**F-75116 Paris (FR)**

(74) Mandataire : **Ballot, Paul Denis Jacques et al**
**Cabinet Ballot-Schmit, 7, rue le Sueur**
**F-75116 Paris (FR)**

EP 0 409 697 B1

## Description

L'invention se rapporte aux circuits intégrés MOS, (métal, Oxyde-Semi-Conducteur) et plus particulièrement aux circuits intégrés dans lesquels la tension de seuil est ajustable précisément.

Les circuits intégrés de type MOS utilisent un ou deux types de transistors pour réaliser toutes les fonctions du circuit. Dans les technologies les plus récentes, ce sont des transistors du type n et du type p. Avec ces deux types de transistors il est possible de réaliser très facilement toutes les fonctions logiques, c'est à dire toutes les fonctions utilisant uniquement des portes logiques et des réseaux logiques programmables, PLA (pour programmable logic arrays).

Les problèmes deviennent plus difficiles à résoudre lorsqu'il s'agit de réaliser des fonctions qui sortent de la logique classique. Or, la plupart des circuits actuels nécessitent au moins une fonction plus ou moins analogique. C'est le cas par exemple de la remise à zéro lors de la mise sous tension (power-on reset selon la terminologie anglosaxonne) ; c'est le cas également des détecteurs de niveau de tension, des amplificateurs de lecture de mémoire, des amplificateurs opérationnels, des convertisseurs analogiques-numériques ou numériques-analogiques, etc...Tous ces circuits nécessitent des références de tension analogiques, et le problème est la précision de ces références.

Avec des circuits intégrés classiques cette précision est souvent très difficile à obtenir du fait de la variation des paramètres des transistors suivant les différents lots de production desquels ils proviennent. En effet, le fonctionnement d'un transistor en régime de saturation peut être décrit par une équation qui exprime le courant de drain $I_D$, en fonction notamment de la tension entre la grille et la source $V_{GS}$, et de la tension de seuil $V_T$ du transistor. Tous ces paramètres varient suivant les lots de production, et le contrôle précis de la valeur du courant de drain en fonction de la tension de commande grille-source est impossible.

Le problème est encore plus difficile quand un circuit nécessitant une grande précision utilise deux types de transistors, type n et type p. En effet les paramètres électriques de ces deux types de transistors peuvent varier dans des directions opposées, ce qui conduit à des dispersions importantes dans le fonctionnement d'un tel type de circuits. Le paramètre qui influe le plus sur les caractéristiques du transistor est sa tension de seuil. Or cette tension de seuil varie avec la variation de la tension de la source du transistor. En conséquence, même si la tension de seuil $V_{TO}$ peut être ajustée précisément lorsque la source est reliée à la masse, il est très difficile d'obtenir des valeurs de fonctionnement stables en régime de fonctionnement.

L'invention a pour objet une cellule MOS dans laquelle la tension de seuil des transistors est rendue ajustable. Une telle cellule MOS est par exemple décrite dans la demande de brevet européen EP-A-0 280 883. Cependant cette demande de brevet n'indique pas en quoi on pourrait obtenir un seuil ajustable avec une telle cellule.

Selon l'invention, on résout ces problèmes avec un procédé de production d'une tension de seuil ajustable comportant les étapes indiquées dans la revendication 1.

L'invention sera mieux comprise et d'autres caractéristiques apparaîtront à l'aide de la description qui suit en référence aux figures annexées.

La figure 1 illustre un circuit générant une tension de référence simple selon l'art antérieur ;

Les figures 2a et 2b illustrent respectivement le schéma en coupe d'une cellule programmable et effaçable électriquement, et le schéma électrique équivalent ;

Les figures 3a et 3b illustrent la cellule polarisée respectivement durant les deux phases nécessaires à l'ajustement de la tension de seuil ;

La figure 4 illustre la caractéristique de la cellule $I_{DS}=f(V_G)$ pour différentes tensions de seuil ;

La figure 5 illustre un circuit de génération d'une tension de référence selon l'invention ;

La figure 6 illustre un circuit de détection d'un niveau d'entrée selon l'invention.

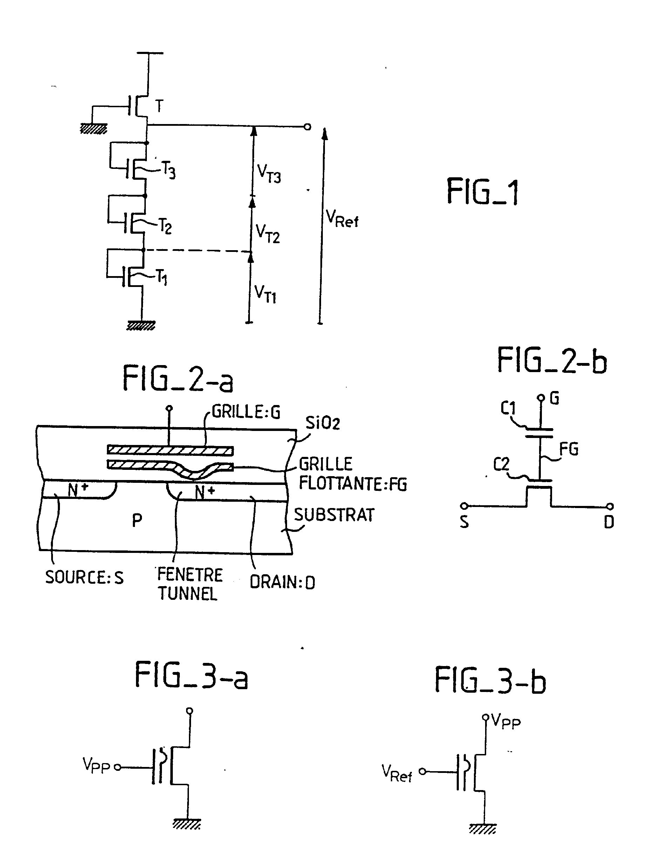

Sur la figure 1 qui illustre l'art antérieur, pour générer une tension de référence $V_{ref}$, égale à 3 fois la tension de seuil d'un transistor, on utilise trois transistors $T_1$, $T_2$, $T_3$, reliés en série entre la masse et la source d'un transistor de sortie T dont le drain est relié à la tension d'alimentation, la grille de ce dernier transistor de sortie, étant reliée à la masse. Chacun des transistors $T_1$, $T_2$, et $T_3$ a son drain relié à sa grille. Dans ces conditions, la tension de seuil $V_{TO}$, lorsque la tension grille-source des transistors est nulle étant supposée égale pour ces trois transistors, la tension de référence de sortie est égale à la somme des tensions de seuil des trois transistors, $V_{T1}+V_{T2}+V_{T3}$. La tension de source du premier transistor $T_1$ étant nulle, la tension de seuil $V_{T1}$ est égale à $V_{TO}$. Par contre, la tension de source du transistor $T_2$ est égale à la tension de seuil $V_{T1}$ ; de même la tension de source du transistor $T_3$ est égale à la tension $V_{T2} + V_{T1}$. En conséquence la tension de référence $V_{réf}$ est :

$$V_{ref} = V_{TO} + (V_{TO} + A V_{TO}) + (V_{TO} + B(V_{TO} + AV_{TO}))$$
$$V_{ref} = V_{TO} (3 + A + B + AB)$$

où A et B sont les coefficients de variation des seuils des transistors, en fonction de la tension de source. Ces coefficients liés à l'effet de substrat peuvent, comme indiqué ci-dessus, varier beaucoup d'un lot de production à l'autre. En conséquence la tension de sortie varie également, et la tension supposée de référence n'est pas stable d'un montage à l'autre. Pour obtenir une tension de référence stable il faudrait que la série des trois transistors soit remplacée par un seul transistor ayant une tension de seuil trois fois plus grande , et que cette tension de seuil soit stable.

L'invention a pour objet un circuit intégré dans lequel on "fabrique" un transistor ayant une tension de seuil parfaitement connue et ajustable dans une large gamme de tension. Pour cela le circuit intégré MOS suivant l'invention utilise la structure de base des cellules mémoire programmables et effaçables électriquement.

La figure 2a illustre la structure d'une telle cellule mémoire MOS programmable et effaçable électriquement dans un mode de réalisation particulièrement bien adapté à l'invention. Cette cellule est constituée d'un substrat de type P dans lequel sont implantées des zones dopées $N^+$ pour former la source S et le drain D, l'ensemble étant recouvert d'une couche d'oxyde de silicium puis d'une grille en polysilicium, FG dite flottante parce que non connectée, séparée d'une seconde grille en polysilicium G par une seconde couche d'oxyde de silicium. Un contact est pris sur la grille G. La grille flottante FG et la grille G sont donc empilées et recouvrent partiellement le drain D. La grille G n'est séparée du drain, que par une couche d'oxyde de silicium amincie pour former une fenêtre tunnel. Le fonctionnement d'une telle cellule est tel que par application d'un champ électrique important entre le drain et la grille des charges traversent l'oxyde de silicium au niveau de la fenêtre tunnel stockées sous la grille flottante FG. Le schéma électrique équivalent représenté sur la figure 2b montre la source S le drain D la capacité du transistor C2 et une capacité de couplage $C_1$ entre la grille flottante FG et la grille de commande G. Ainsi si le seuil du transistor est égal à $V_{TO}$, le seuil de la cellule mémoire est égal à :

$$V_{TC} = (C_1 + C_2)/ C_1 \times V_{TO} = KV_{TO}.$$

Comme indiqué ci-dessus le seuil $V_{TO}$ est un paramètre technologique qui ne peut pas être modifié.

Une telle cellule a la propriété de permettre le stockage des charges, c'est à dire l'effacement de la cellule (état "1" où le transistor est passant pour une tension de lecture $V_L$), puis la suppression des charges sur la grille flottante FG à la programmation de la cellule (état "O" où le transistor est bloqué pour la tension de lecture $V_L$). Le stockage des charges équivaut à l'application d'une tension initiale sur la grille flottante FG qui décale la caractéristique $I_{DS} = F(V_G)$: ainsi si par exemple ces charges sont négatives il faudra appliquer une tension positive sur la grille de commande G pour compenser ses charges. La tension de seuil est alors :

$$V_{TC} = K(V_{TO} + V)$$

où V est la tension de la grille flottante quand la grille de commande reçoit une tension nulle. Cette tension V est due aux charges stockées sous la grille flottante.

Il en résulte que par un contrôle des charges stockées sous cette grille, la tension de seuil du dispositif est contrôlée précisément.

Il a été indiqué ci-dessus que "l'effacement" de la cellule c'est à dire le stockage des charges sous la grille flottante, est obtenu par l'application d'un champ électrique élevé entre la grille et le drain, les charges étant transférées par effet tunnel à travers la fenêtre prévue entre le drain et la grille flottante à cet effet. Par exemple, la programmation est obtenue en portant la grille de commande à la masse, le drain étant porté à 20 volts, l'épaisseur de la fenêtre tunnel étant de 0.01 micromètre. La source est alors à un potentiel flottant. Pour l'effacement la source est portée à la masse et la grille au fort potentiel (20 volts) le drain étant non connecté : les charges précédemment stockées sont évacuées et le transistor est bloqué. Pour obtenir le circuit à seuil variable, on procède un peu de la même manière analogue, en deux phases. Dans une première phase, la source est portée à la masse tandis que la grille est portée à haute tension (20 volts environ) : les électrons éventuellement stockés sur la grille flottante sont évacués et la tension de seuil est la tension $V_{TO}$ de l'ordre de 5 volts ;

Dans une deuxième phase, la source étant toujours portée à la masse, la grille est portée à un potentiel de référence $V_{réf}$, et le drain est porté à la haute tension de programmation $V_{PP}$. La tension de référence est égale à la tension de seuil que l'on souhaite obtenir.

La tension $V_{PP}$ monte doucement jusqu'au moment où l'effet tunnel est déclenché. Les charges s'accumulent alors sous la grille flottante. Quand le nombre de charges est tel que la tension de seuil atteint $V_{ref}$ le transistor commence à conduire ; le courant qui apparaît sur le drain fait baisser la tension de programmation $V_{PP}$ et celle-ci s'arrête alors de croître. Les charges sont piégées et les bornes de la cellule peuvent être déconnectées. La valeur de tension de seuil ainsi obtenue est très précise et indépendante des paramètres technologiques liés au procédé de fabrication du circuit.

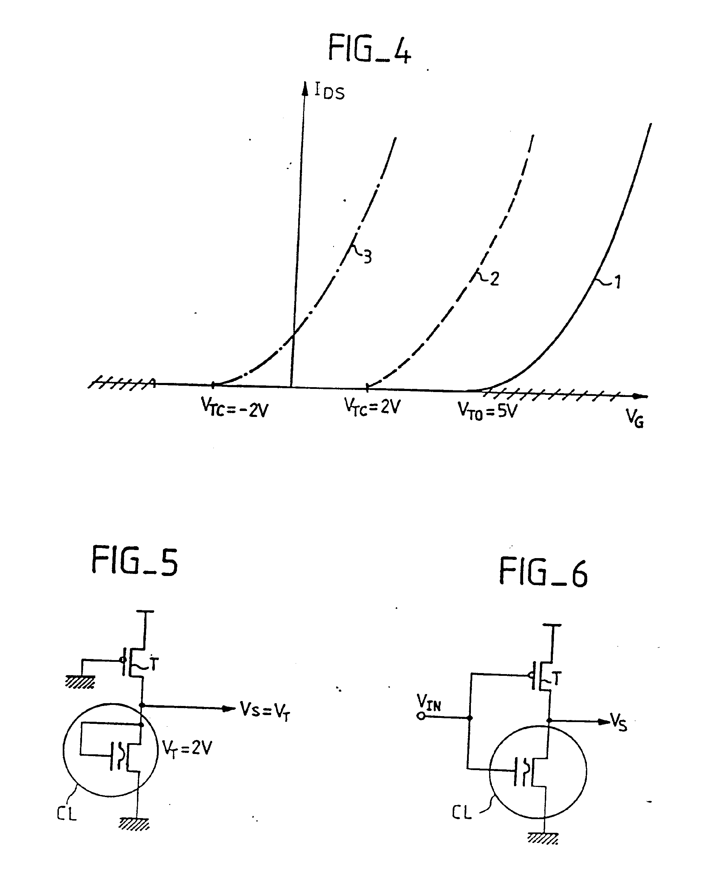

La figure 4 illustre les caractéristiques de la cellule d'abord avec sa tension de seuil initiale $V_{TO} = 5V$ par exemple, courbe 1, en l'absence de charges stockées sous la grille flottante et $V_G = V_0$, puis avec une tension de seuil $V_{TC} = 2V$, la tension de référence appliquée à la grille ayant été portée $V_{ref} = 2V$, courbe 2, puis avec une tension de seuil $V_{TC} = -2V$, la tension de référence appliquée à la grille étant $V_{ref}$: -2V, courbe 3.

L'utilisation d'un tel circuit intégré MOS à tension de seuil ajustable est possible pour de nombreuses applications. Deux exemples sont donnés en référence aux figures 5 et 6. La figure 5 est un exemple d'application dans lequel la cellule à tension de seuil ajustable est utilisée pour obtenir une tension de référence fixe. Pour cela, la cellule CL avec les charges stockées pour que la tension de seuil soit $V_T = 2$ volts, est connectée entre la source du transistor MOS T de sortie et la masse, la grille de la cellule étant reliée à son drain. La grille du transistor T est reliée à la masse et son drain à une tension d'alimentation. Ainsi, la tension de sortie $V_S$ sur le drain du transistor de sortie T est égale à la tension de seuil $V_T = 2$ volts de la cellule. Comme indiqué ci-dessus, avant son utilisation, pour fixer une tension de référence, la cellule est calibrée au cours d'une calibration préalable en deux phases, comme indiqué ci-dessus. La figure 6 représente un deuxième mode d'utilisation de la cellule à tension de seuil ajustable décrite ci-dessus dans un circuit de détection de tension. Le circuit comporte une cellule CL programmée par stockage de charges sur la grille flottante pour que sa tension de seuil soit égale à $V_T = 2$ volts par exemple, dont le drain est relié au drain d'un transistor de sortie T et dont la source est reliée à la masse, la source du transistor de sortie T étant reliée à une tension d'alimentation, et les deux grilles de la cellule d'une part et du transistor T d'autre part étant reliées à une borne d'entrée destinée à recevoir la tension à détecter $V_{IN}$. Ce circuit fonctionne de la manière suivante. Tant que la tension $V_{IN}$ est inférieure au seuil $V_T$, la cellule ne conduit pas et la tension de sortie $V_s$ est la tension d'alimentation du circuit. Dès que la tension $V_{IN}$ devient supérieure au seuil $V_T$, la cellule conduit, et la tension de sortie $V_S$ diminue. Le fonctionnement de ce circuit peut donc être analysé comme celui d'un inverseur qui fait basculer la sortie dès que la tension d'entrée dépasse la tension de seuil $V_T$. Un tel circuit est utilisable notamment pour réaliser des convertisseurs analogiques-numériques, ou pour le décalage de niveaux de tension.

Un troisième exemple d'utilisation d'une telle cellule à tension de seuil ajustable est la réalisation de transistors déplétés à tension de seuil $V_T$ négative sans nécessiter de masques et d'étapes de fabrication supplémentaires. En effet, dans les circuits CMOS, l'utilisation de transistors déplétés peut simplifier considérablement les structures du circuit. Mais dans un circuit comportant quelques milliers de transistors, un seul transistor déplété peut être nécessaire. La cellule décrite ci-dessus permet d'ajuster la tension de seuil à une valeur négative aussi bien qu'à une valeur positive.

Un grand avantage de l'invention est lié au fait que la tension de seuil est très précise et que sa valeur peut être tout à fait, analogique, c'est à dire est ajustée à une valeur quelconque choisie dans la gamme -4à +5 V par exemple.

L'invention n'est pas limitée aux applications précisément décrites ci-dessus. En particulier tous les circuits nécessitant de commander des fonctions à partir de la détection de certains niveaux d'entrée peuvent être réalisables avec de telles cellules dans lesquelles la tension de seuil est ajustée.

**Revendications**

1. Procédé de production d'une tension de seuil ajustable comportant les étapes suivantes :
   - on prend une cellule du type à mémoire dans un circuit intégré, cette cellule du type à mémoire étant du type avec un transistor à grille flottante, programmable et effaçable électriquement par stockage de charges par effet tunnel dans la grille flottante de ce transistor, sous l'effet d'un champ intense, une cellule mémoire de ce type étant lisible en soumettant une des bornes de cette cellule à un potentiel de lecture l'état lu étant déduit de la mise en conduction ou non de ce transistor à grille flottante, le circuit intégré étant en permanence connecté d'une part à une tension d'alimentation et d'autre part à la masse, caractérisé en ce que
   - on porte la source de ce transistor à grille flottante à un potentiel de masse, la grille de commande de ce transistor à grille flottante à une tension qui est égale à cette tension de seuil, et le drain de ce transistor à grille flottante à une haute tension de programmation,
   - la tension de seuil est alors ajustée dans une phase de calibration par stockage d'une quantité prédéfinie de charges sous la grille flottante, dans cette phase la tension de programmation monte jusqu'au moment où l'effet tunnel est déclenché, les charges s'accumulent alors sous la grille flottante, puis le transistor commence à conduire et le courant qui apparaît sur le drain fait baisser la tension de programmation qui cesse de croître, la tension de seuil étant ainsi obtenue.

2. Procédé selon la revendication 1, caractérisé en ce que
   - on relie ensuite la grille de commande de cette cellule à son drain et on alimente cette cellule entre le potentiel de masse et la tension d'alimentation avec un transistor connecté en série avec elle.

3. Procédé selon la revendication 1, caractérisé en ce que
   - on relie ensuite la grille de commande du transistor à grille flottante de cette cellule à celle d'un transistor de commande, et le drain du transistor à grille flottante de cette cellule au drain de ce transistor de commande, on alimente cette cellule en série avec ce transistor entre la masse et une tension d'alimentation,
   - on soumet les grilles de commandes reliées à une tension à tester, ce montage délivrant en sortie un signal représentatif de la comparaison de cette tension à tester à la valeur de la tension de seuil.

4. Procédé selon l'une quelconque des revendications 1 à 3, caractérisé en ce que la tension de seuil est ajustée en deux phases :
   - une première phase au cours de laquelle une quantité prédéfinie de charges est stockée dans la grille flottante, un champ électrique au moins égal au champ nécessaire au transfert par effet tunnel étant appliquée dans une fenêtre, la cellule ayant sa source portée à la masse, sa grille de commande portée à une haute tension de programmation,
   - et une deuxième phase au cours de laquelle la cellule a sa grille de commande portée à une tension de référence ($V_{ref}$) égale à la tension de seuil souhaitée ($V_{TC}$), sa source portée à un potentiel de masse, et son drain porté à ladite haute tension de programmation.

**Patentansprüche**

1. Verfahren zum Erzeugen einer einstellbaren Schwellenspannung mit den folgenden Stufen:
   - es wird eine Zelle vom Typ mit Speicher in einer integrierten Schaltung genommen, wobei die Zelle vom Typ mit Speicher ein Typ mit einem Transistor mit schwimmendem Gate ist, der elektrisch programmierbar und löschbar durch Speicherung von Ladungen durch den Tunneleffekt in das schwimmende Gate dieses Transistors unter dem Einfluß eines starken Feldes ist, wobei eine Speicherzelle dieses Typs dadurch gelesen werden kann, daß an eine der Anschlußklemmen dieser Zelle ein Lesepotential angelegt wird, wobei der gelesene Zustand davon abgeleitet wird, ob der Transistor mit schwimmendem Gate in den leitenden Zustand versetzt ist oder nicht, wobei die integrierte Schaltung dauerhaft einerseits an eine Versorgungsspannung und andererseits an Masse angelegt ist, dadurch gekennzeichnet,
   - daß der Source-Anschluß dieses Transistors mit schwimmendem Gate an ein Massepotential angelegt wird, das Steuer-Gate dieses Transistors mit schwimmendem Gate an eine Spannung angelegt wird, die gleich dieser Schwellenspannung ist, und der Drain-Anschluß dieses Transistors mit schwimmendem Gate an eine hohe Programmierspannung angelegt wird,
   - die Schwellenspannung dabei in einer Eichphase durch Speichern einer vorbestimmten Ladungsmenge unter dem schwimmenden Gate eingestellt wird, wobei in dieser Phase die Programmierspannung bis zu dem Zeitpunkt ansteigt, an dem der Tunneleffekt ausgelöst wird, wobei sich die Ladungen dabei unter dem schwimmenden Gate ansammeln, worauf dann der Transistor zu leiten beginnt und der an dem Drain-Anschluß erscheinende Strom die Programmierspannung absenkt, die aufhört, anzusteigen, so daß die Schwellenspannung auf diese Weise erhalten wird.

2. Verfahren nach Anspruch 1, dadurch gekennzeichnet, daß
   - das Steuer-Gate dieser Zelle anschließend mit ihrem Drain-Anschluß verbunden wird und diese Zelle zwischen dem Massepotential und der Versorgungsspannung mit einem in Serie zu ihr geschalteten Transistor gespeist wird.

3. Verfahren nach Anspruch 1, dadurch gekennzeichnet, daß
   - das Steuer-Gate des Transistors mit schwimmendem Gate dieser Zelle mit dem eines Steuertransistors verbunden wird und der Drain-Anschluß des Transistors mit schwimmendem Gate dieser Zelle mit dem Drain-Anschluß dieses Steuertransistors verbunden wird, wobei diese Zelle in Serie mit diesem Transistor zwischen Masse und einer Versorgungsspannung gespeist wird,
   - die verbundenen Steuer-Gates an eine zu prüfende Spannung gelegt werden, wobei diese Schaltung am Ausgang ein Signal abgibt, das den Vergleich dieser zu prüfenden Spannung mit dem Wert der Schwellenspannung repräsentiert.

4. Verfahren nach einem der Ansprüche 1 bis 3, dadurch gekennzeichnet, daß die Schwellenspannung in zwei Stufen eingestellt wird:
   - in einer ersten Stufe, in deren Verlauf eine vorbestimmte Ladungsmenge in dem schwimmenden Gate gespeichert wird, ein elektrisches Feld, das wenigstens gleich dem zum Übertragen durch den Tunneleffekt notwendigen Feld ist, an ein Fenster angelegt wird, wobei der Source-Anschluß der Zelle an Masse gelegt ist und ihr Steuer-Gate an eine hohe Programmierspannung angelegt ist,
   - und in einer zweiten Stufe, in deren Verlauf das Steuer-Gate der Zelle an eine Referenzspannung ($V_{ref}$) gelegt wird, die gleich der gewünschten Schwellenspannung (V$_{TC}$) ist, wobei ihr Source-Anschluß an ein Massepotential gelegt ist und ihr Drain-Anschluß an die hohe Programmierspannung gelegt ist.

## Claims

1. Process for producing an adjustable threshold voltage, comprising the following steps:
   - a cell of the memory type is selected in an integrated circuit, this cell of the memory type being of the type having a floating grid transistor which is programmable and effaceable electrically by the storage of charges through the tunnel effect in the floating grid of the said transistor, under the effect of an intense field, a memory cell of this type being readable by exposing one of the terminals of this cell to a reading potential, the read state being deduced from whether or not this floating grid transistor is rendered conductive, the integrated circuit being permanently connected on the one hand to a supply voltage and on the other hand to earth, characterised by the fact that
   - the source of this floating grid transistor is brought to an earth potential, the control grid of this floating grid transistor to a voltage equal to the said threshold voltage, and the drain of this floating grid transistor to a high programming voltage,
   the threshold voltage being then adjusted in a calibration phase by the storage of a predefined quantity of charges under the floating grid, in which phase the programming voltage increases until the moment when the tunnel effect is set up, the charges then accumulating under the floating grid, the transistor then commencing to conduct and the current which occurs on the drain causing a fall in the programming voltage, which ceases to increase, the threashold voltage being obtained in this manner.

2. Process in accordance with claim 1, characterised by the fact that
   - the control grid of this cell is connected to its drain and this cell is fed between the earth-potential and the supply voltage with a transistor connected thereto in series.

3. Process in accordance with claim 1, characterised by the fact that
   - the control grid of the floating grid transistor is then connected to that of a control transistor, while the drain of the floating grid transistor of this cell is connected to the drain of this control transistor, and this cell is fed in series with this transistor between the earth and a supply voltage,
   - the connected control grids are subjected to a voltage to be tested, this assembly supplying at its output a signal which represents a comparison of this voltage to be tested with the value of the threshold voltage.

4. Process in accordance with any of claims 1 to 3, characterised by the fact that the threshold voltage is adjusted in two phases:
   - a first phase in the course of which a predefined quantity of charges is stored in the floating grid, an electrical field at least equal to the field required for the transfer by the tunnel effect being applied in a window, the source of the cell being put at earth potential and its control grid put at a high programming voltage,
   - and a second phase in the course of which the control grid of the cell is brought to a reference (V$_{ref}$) equal to the desired threshold voltage (V$_{TC}$), its source being put at an earth potential and its drain being brought to the said high programming voltage.

FIG_1

FIG_2-a

FIG_2-b

FIG_3-a

FIG_3-b

# FIG_4

# FIG_5

$V_S = V_T$

$V_T = 2V$

CL

# FIG_6

$V_{IN}$

$V_S$

CL